(19) Europäisches Patentamt / European Patent Office / Office européen des brevets

(11) **EP 4 029 107 B1**

(12) **FASCICULE DE BREVET EUROPEEN**

(45) Date de publication et mention
de la délivrance du brevet:
**04.10.2023 Bulletin 2023/40**

(21) Numéro de dépôt: **20736350.8**

(22) Date de dépôt: **08.07.2020**

(51) Classification Internationale des Brevets (IPC):
**G01R 31/52** *(2020.01)* **H02J 7/04** *(2006.01)*
**G01R 31/36** *(2020.01)* **H02J 7/16** *(2006.01)*
**G01R 31/00** *(2006.01)*

(52) Classification Coopérative des Brevets (CPC):
**H02J 7/04; G01R 31/52; H02J 7/16;** G01R 31/006;
Y02T 10/70; Y02T 10/7072

(86) Numéro de dépôt international:
**PCT/EP2020/069191**

(87) Numéro de publication internationale:
**WO 2021/047803 (18.03.2021 Gazette 2021/11)**

(54) **DISPOSITIF D'ESTIMATION ET DE COMPENSATION DES COURANTS DE FUITE D'UN CHARGEUR DE BATTERIE, VÉHICULE ÉQUIPÉ D'UN TEL DISPOSITIF ET MISE EN OEUVRE DU DISPOSITIF**

VORRICHTUNG ZUR SCHÄTZUNG UND KOMPENSATION DER LECKSTRÖME EINES BATTERIELADEGERÄTS, FAHRZEUG MIT EINER SOLCHEN VORRICHTUNG UND EINSATZ EINER SOLCHEN VORRICHTUNG

DEVICE FOR ESTIMATING AND COMPENSATING FOR THE LEAKAGE CURRENTS OF A BATTERY CHARGER, VEHICLE PROVIDED WITH SUCH A DEVICE AND IMPLEMENTATION OF THE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.09.2019 FR 1910120**

(43) Date de publication de la demande:
**20.07.2022 Bulletin 2022/29**

(73) Titulaire: **Renault S.A.S.**
**92100 Boulogne-Billancourt (FR)**

(72) Inventeurs:
• **GARCIA ITURRICHA, Aitor**
**75014 PARIS (FR)**
• **JAAFAR, Ali**
**91400 ORSAY (FR)**

(74) Mandataire: **Renault Group**
**Renault s.a.s.**
**1 avenue du Golf**
**FR TCR AVA 055**
**78084 Guyancourt Cedex (FR)**

(56) Documents cités:
**CN-U- 204 967 321      US-A1- 2011 273 139
US-A1- 2012 019 194**

**Description**

La présente invention concerne les chargeurs et la mise en oeuvre des chargeurs dans un véhicule automobile électrique ou hybride.

Elle concerne plus particulièrement un dispositif d'estimation et de compensation des courants de fuite d'un chargeur de batterie et la mise en oeuvre dudit dispositif.

Généralement, un véhicule automobile hybride ou électrique comprend un chargeur pour recharger une batterie alimentant un moteur électrique de traction du véhicule.

Le chargeur peut être du type non isolé permettant une intégration du chargeur dans le véhicule plus aisé que celle d'un chargeur du type isolé.

Cependant, les composants du chargeur de type non isolé sont exposés à diverses perturbations électriques extérieures au chargeur, notamment des perturbations générées par l'infrastructure de charge alimentant le chargeur, et comportant une borne de charge et un réseau d'alimentation alimentant la borne de charge.

Lors de la charge, des convertisseurs de puissance comportant par exemple des transistors génèrent des courants de fuite qui pour une partie sont filtrés par des capacités de mode commun du chargeur, et, pour une autre partie circulent vers la terre.

Les courants de fuite circulant dans la terre sont rebouclés par le réseau d'alimentation et génèrent des perturbations électriques dans le réseau en interagissant notamment avec le chargeur et les autres appareils connectés (interactions à « double sens » ou cycliques) créant des surtensions et des surintensités susceptibles de détériorer le chargeur.

Afin d'empêcher la détérioration du chargeur, le chargeur peut comprendre un disjoncteur différentiel déconnectant le chargeur lorsqu'un courant différentiel mesuré en entrée du chargeur est supérieur à un seuil de sécurité.

Cependant la charge est interrompue.

Les interactions à « double sens » ou cycliques sont difficilement quantifiables car elles dépendent notamment de la topologie du circuit de puissance du système de charge, des capacités parasites du véhicule dépendantes de la configuration du véhicule, des algorithmes de pilotage des composants de puissance embarqués dans le véhicule (notamment la régulation de la charge), et des connexions en amont de la borne de

Les documents US 2012/019194 A1, CN 204 967 321 U et US 2011/273139 A1 proposent différentes méthodes pour limiter les courants de fuite lors de la recharge de la batterie d'un véhicule électrique.

Le document US9,696,743 propose une méthode pour compenser les courants de fuite en mesurant les courants de fuite circulant aux points de connexion avec la terre puis en injectant des courants de valeur inverse pour annuler l'effet des courants de fuite.

Cependant, cette méthode est difficilement implémentable pour un dispositif complexe comportant une multitude d'interfaces entre le dispositif et la terre tel qu'un chargeur.

Les documents :

- (S. Haghbin, S. Lundmark, M. Alaküla and O. Carlson - Grid-Connected Integrated Battery Chargers in Vehicle Applications: Review and New Solution, IEEE TRANSACTIONS ON INDUSTRIAL ELECTRONICS, VOL. 60, NO. 2, FEBRUARY 2013),
- (I. Subotic, N. Bodo, E. Levi, B. Dumnic, D. Milicevic, V. Katic - Overview of fast on-board integrated battery chargers for electric vehicles based on multiphase machines and power electronics, IET Electric Power Applications, ISSN 1751-8660),
- (Yilmaz and P. T. Krein - Review of Battery Charger Topologies, Charging Power Levels, and Infrastructure for Plug-In Electric and Hybrid Vehicles, IEEE TRANSACTIONS ON POWER ELECTRONICS, VOL. 28, NO. 5, MAY 2013), et
- (Y. Zhang et al. - Leakage Current Issue of Non-Isolated Integrated Chargers for Electric Vehicles, Proceedings of the 2018 IEEE Energy Conversion Congress and Exposition (ECCE), Portland, OR, USA, 23-27 Sept. 2018) proposent d'ajouter des composants dans la chaîne de conversion d'énergie ou de reconfigurer des connexions électriques d'un moteur électrique pour améliorer l'isolation électrique afin de minimiser les courants de fuites.

Cependant, ces modifications entraînent une augmentation de la complexité de la régulation de la charge, une augmentation des courants magnétiques dans les noyaux du stator du moteur électrique, une dégradation de l'efficacité de la charge, et sont susceptibles d'alimenter le rotor du moteur électrique pendant la charge.

Les approches proposées dans l'état de la technique cherchent à minimiser la circulation des courants de fuite, et ne permettent pas de supprimer l'apparition de surtensions dans le chargeur.

Le but de l'invention est de pallier tout ou partie de ces inconvénients.

Au vu de ce qui précède, l'invention propose un procédé d'estimation et de compensation des courants de fuite d'un chargeur de batterie pour véhicule automobile électrique ou hybride, comportant, lors d'une charge, la mesure d'un courant résiduel différentiel entre le chargeur et un réseau d'alimentation du chargeur, la comparaison du courant résiduel à un seuil de déclenchement, et la détermination d'une consigne de charge à partir d'un profil de charge prédéterminé selon le résultat de la comparaison.

Lorsque le courant résiduel est supérieur au seuil de déclenchement, la consigne de charge comprend une consigne de charge sécuritaire configurée pour limiter la valeur des courants de fuite à une valeur admissible des courants de fuite de manière à ne pas interrompre la charge, la consigne de charge sécuritaire étant déterminée à partir de la différence entre le courant résiduel différentiel mesuré et le seuil de déclenchement, ladite différence étant amplifiée par un amplificateur à gain variable dépendant d'un courant déterminé à partir du profil de charge puis injectée en entrée d'un filtre implémentant un modèle dynamique, la sortie dudit modèle dynamique étant ajoutée au courant déterminé à partir du profil de charge pour fournir ladite consigne de charge sécuritaire.

Selon une caractéristique, le procédé comprend l'identification du type du réseau d'alimentation du chargeur et la détermination du seuil de déclenchement et de la valeur maximale admissible des courants de fuite en fonction du type du réseau d'alimentation identifié.

De préférence, le modèle dynamique comprend une fonction de transfert du premier ordre, la détermination des paramètres de la fonction de transfert comprenant une identification fréquentielle de l'infrastructure de charge.

Avantageusement, le gain variable dépend d'une fonction polynomiale.

Selon une autre caractéristique, les coefficients de la fonction polynomiale sont déterminés de manière empirique.

L'invention a aussi pour objet un dispositif d'estimation et de compensation des courants de fuite d'un chargeur de batterie pour véhicule automobile électrique ou hybride, comportant des moyens de mesure d'un courant configurés pour mesurer, lors d'une charge, un courant résiduel différentiel entre le chargeur et un réseau d'alimentation du chargeur, des premiers moyens de comparaison configurés pour comparer le courant résiduel mesuré à un seuil de déclenchement, et des moyens de traitement configurés pour déterminer une consigne de charge à partir d'un profil de charge prédéterminé.

Les moyens de traitement sont configurés pour déterminer, lorsque le courant résiduel est supérieur au seuil de déclenchement, une consigne de charge comprenant une consigne de charge sécuritaire configurée pour limiter la valeur des courants de fuite à une valeur admissible des courants de fuite de manière à ne pas interrompre la charge, lesdits moyens de traitement comportant un amplificateur à gain variable de la différence entre le courant résiduel différentiel mesuré et le seuil de déclenchement, ledit amplificateur à gain variable dépendant d'un courant déterminé à partir du profil de charge et étant connecté en entrée d'un filtre implémentant un modèle dynamique, la sortie dudit filtre étant connectée à un additionneur additionnant ladite sortie dudit filtre et le courant déterminé à partir du profil de charge pour fournir ladite consigne de charge sécuritaire.

Selon une caractéristique, le dispositif comprend des moyens d'identification configurés pour identifier le type de réseau d'alimentation du chargeur, les moyens d'identification étant en outre configurés pour déterminer le seuil de déclenchement et la valeur admissible des courants de fuite en fonction du type du réseau d'alimentation identifié.

De préférence, le modèle dynamique est configuré pour approximer le comportement dynamique de l'infrastructure de charge comprenant le réseau d'alimentation relié au chargeur et les courants de fuite.

Avantageusement, le modèle dynamique comprend une fonction de transfert du premier ordre.

L'invention a aussi pour objet un véhicule automobile électrique ou hybride comprenant un chargeur de batterie comportant un régulateur de charge et un dispositif d'estimation et de compensation des courants de fuite d'un chargeur tel que défini précédemment, ledit dispositif pilotant le régulateur de charge.

D'autres buts, caractéristiques et avantages de l'invention apparaîtront à la lecture de la description suivante, donnée uniquement à titre d'exemple non limitatif, et faite en référence aux dessins annexés sur lesquels :

[Fig 1] illustre un exemple d'un véhicule automobile électrique ou hybride selon l'invention ;
[Fig 2] illustre un exemple de réalisation du module de traitement selon l'invention ;
[Fig 3] illustre un exemple de mise en oeuvre du dispositif d'estimation et de compensation des courants de fuite selon l'invention ; et
[Fig 4] illustre un exemple d'évolution temporelle du courant différentiel selon l'état d'activation du dispositif d'estimation et de compensation des courants de fuite selon l'invention.

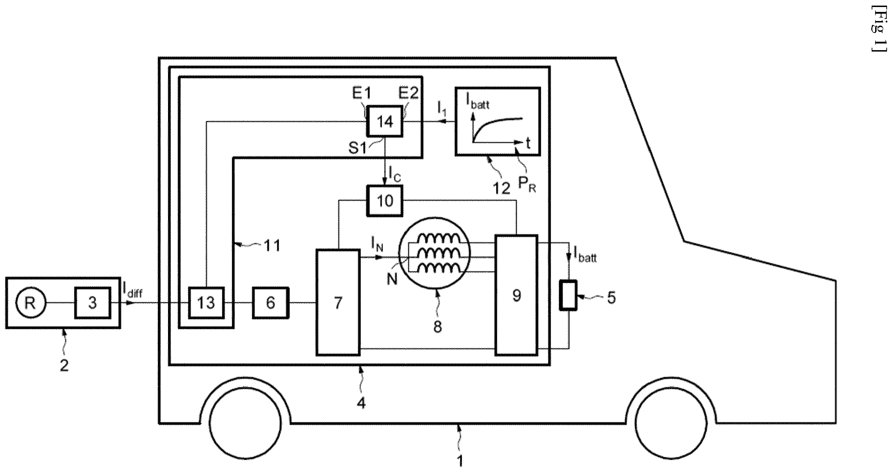

On se réfère à la figure 1 qui illustre un véhicule 1 automobile électrique ou hybride relié à une infrastructure de charge 2 comprenant une borne de charge 3 et un réseau d'alimentation électrique R alimentant la borne de charge 3.

Le véhicule 1 comprend un chargeur 4 de batterie relié à la borne de charge 3 et une batterie 5 reliée au chargeur 4 de sorte que lorsque le réseau R charge la batterie 5, un courant $I_{BATT}$ circule aux bornes de la batterie 5.

Le réseau R délivre une tension alternative monophasée, par exemple 230V ou triphasée, par exemple 380V.

Le chargeur 4 comprend un étage de filtration 6 comprenant une entrée reliée à la borne 3 et configuré pour éviter le rejet de perturbations électriques sur le réseau R générés notamment par des opérations de conversion de puissance au sein du chargeur 4, un étage redresseur et abaisseur de tension 7 comprenant une entrée reliée à une sortie de l'étage de filtrage 6 en mode commun, et un moteur 8 électrique de traction triphasé comprenant un bobinage statorique relié en étoile dont le point neutre N est relié à une sortie de l'étage redresseur et abaisseur de tension 7, un courant neutre $I_N$ circulant entre l'étage 7 et le moteur 8.

L'étage redresseur et abaisseur de tension 7 redresse et abaisse la tension alternative délivrée par le réseau R, et comprend un convertisseur de puissance du type « Buck » et au moins une inductance de lissage pour lisser le courant continu généré suite aux opérations de redressage et d'abaissement de la tension.

Le bobinage statorique de la machine 8 est également utilisé pour lisser le courant continu de sorte que l'inductance dans l'étage 7 peut être de dimensions réduites.

Le chargeur 4 comprend en outre un étage 9 élévateur de tension comprenant des entrées reliées chacune à une phase différente de la machine 8 et une quatrième entrée reliée à une deuxième sortie de l'étage redresseur et abaisseur de tension, des sorties de l'étage 9 étant reliées à la batterie 5.

L'étage 9 élévateur de tension élève la tension et comprend un convertisseur de puissance du type « boost ».

Le chargeur 4 comprend un régulateur 10 de charge configuré pour piloter l'étage redresseur et abaisseur de tension 7 et pour piloter l'étage 9 élévateur de tension selon un courant de consigne de charge $I_C$, un dispositif 11 d'estimation et de compensation des courants de fuite relié au régulateur 10 et générant le courant de consigne de charge $I_C$, et un module 12 de consigne de charge configuré pour générer un courant $I_1$ lors de la charge de la batterie 5 déterminé à partir d'un profil de charge $P_R$ sauvegardé dans le module 12, le courant neutre $I_N$ suivant l'évolution du courant $I_1$ lors de la charge.

Le profil de charge $P_R$ est par exemple déterminé à partir d'une évolution temporelle du courant $I_{BATT}$ lors de la charge de la batterie 5.

Le dispositif 11 d'estimation et de compensation des courants de fuite est configuré pour générer une consigne de charge sécuritaire comprenant un courant de consigne de charge sécuritaire Ics, et configurée pour limiter la valeur des courants de fuite à un seuil de sécurité de manière à ne pas interrompre la charge lorsqu'un courant résiduel différentiel $I_{diff}$ entre le chargeur 4 et le réseau d'alimentation R du chargeur est supérieur à un seuil Se1 de déclenchement.

Le dispositif 11 comprend des moyens de mesure 13 d'un courant configurés pour mesurer un courant résiduel différentiel entre le chargeur et un réseau d'alimentation du chargeur, et un module de traitement 14 comprenant une première entrée E1 reliée aux moyens de mesure 13, une deuxième entrée E2 recevant le courant $I_1$ et une sortie S1 reliée au régulateur 10 sur laquelle circule le courant de consigne de charge $I_C$.

Le courant résiduel différentiel $I_{diff}$ et les courants de fuite sont reliés notamment par une relation comprenant l'impédance équivalente des filtres en mode commun présents dans le chargeur 4, l'impédance des capacités parasites et l'impédance équivalente du réseau R, ces impédances étant difficilement quantifiables.

Par conséquent, le module de traitement 14 comprend un estimateur des effets parasites par modèle partiel utilisant la valeur du courant différentiel résiduel $I_{diff}$ et le point de fonctionnement du régulateur 10 de charge donné par le module 12. L'estimateur détermine en temps réel la dynamique de l'étage de filtrage 6 en mode commun et la dynamique des capacités parasites à partir du courant résiduel différentiel $I_{diff}$ considéré comme une image des courants parasites dans la terre.

Les courants de fuite ou parasites dans la terre sont estimés et utilisés pour compenser leur effet sur la régulation de la charge afin de minimiser leur propagation et leur amplification.

On cherche à supprimer l'apparition de surtensions dans le chargeur.

Les moyens de mesure 13 sont réalisés par exemple à partir d'un noyau magnétique sur lequel sont enroulés des bobinages.

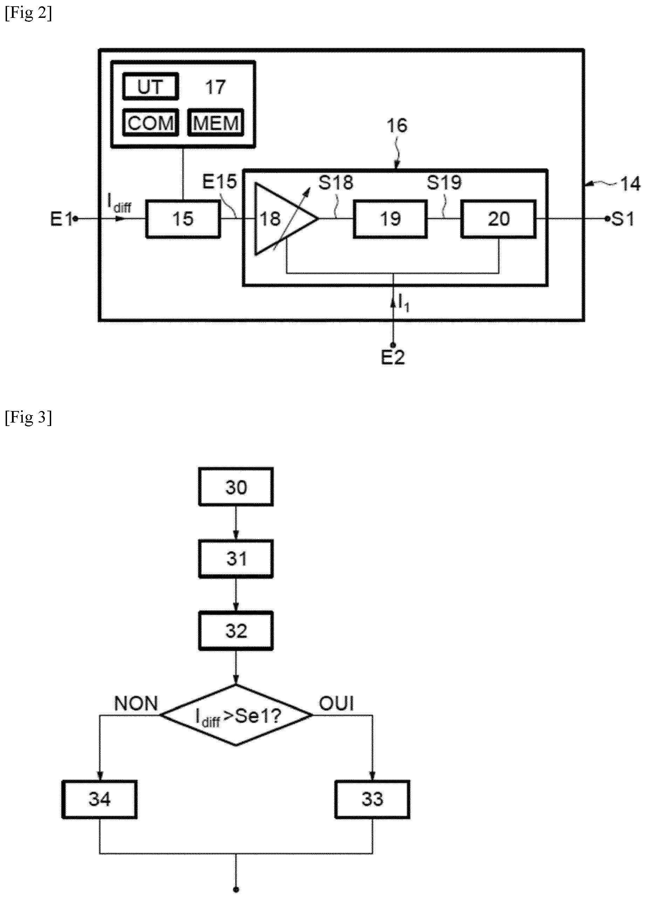

La figure 2 illustre un exemple de réalisation du module de traitement 14.

Le module de traitement 14 comprend des premiers moyens de comparaison 15 configurés pour comparer la valeur du courant résiduel $I_{diff}$ reçu sur la première entrée E1 au seuil de déclenchement Se1 et des moyens de traitement 16 configurés pour déterminer la consigne de charge comportant le courant de consigne de charge $I_C$ à partir du profil de charge $P_R$.

Les moyens de traitement 16 sont configurés pour déterminer, lorsque le courant résiduel $I_{diff}$ est supérieur au seuil de déclenchement Se1, la consigne de charge comprenant le courant de consigne de charge sécuritaire $I_{CS}$, le courant de consigne de charge sécuritaire étant configuré pour limiter la valeur des courants de fuite à une valeur admissible des courants de fuite $I_{diffmax}$ de manière à ne pas interrompre la charge.

Le module 14 comprend en outre des moyens d'identification 17 configurés pour identifier le type du réseau R et sont en outre configurés pour déterminer le seuil de déclenchement Se1 en fonction du type du réseau R identifié et d'un coefficient β de sensibilité variant entre 0 et 1.

Le seuil Se1 est égale à :

$$Se1 = \beta \cdot I_{diffmax} \qquad (1)$$

Par exemple, si les moyens d'identification 17 détectent que le réseau R est du type monophasé inférieur à 12,5 ampères, le courant $I_{diffmax}$ est égal à 70 mA, et dans les autres cas, le courant $I_{diffmax}$ est égal à 171 mA.

Le coefficient $\beta$ est déterminé selon la sensibilité du chargeur 4 aux variations des courants de fuite, et est par exemple égal à 0.75.

Les moyens d'identification 17 comprennent par exemple une mémoire MEM stockant les valeurs maximales des courants de fuite $I_{diffmax}$ et le coefficient $\beta$, un module de communication COM communiquant avec la borne 3 pour déterminer le type du réseau R et une unité de traitement UT configurée pour sélectionner, calculer et transmettre la valeur du seuil Se1 aux premiers moyens 15.

Les premiers moyens 15 calculent une différence E15 pondérée entre le courant résiduel différentiel $I_{diff}$ et le seuil Se1 de déclenchement :

$$E15 = \frac{I_{diff} - \beta I_{diffmax}}{(1-\beta)I_{diffmax}} \qquad \text{si } I_{diff} > \beta . \, I_{diffmax}, \text{ et} \qquad (2)$$

E15=0 sinon

Les moyens de traitement 16 comprennent un amplificateur 18 à gain variable configurés pour être pilotés par le courant $I_1$ et recevant en entrée la différence E15, un filtre 19 implémentant un modèle dynamique du premier ordre configuré pour approximer le comportement dynamique de l'infrastructure de charge 2 et les courants de fuite à partir de la différence E15 amplifiée par l'amplificateur 18, et un additionneur 20 configuré pour additionner une sortie du filtre 19 et le courant $I_1$.

Les premiers moyens de comparaison 15 et l'amplificateur 18 sont par exemple réalisés à partir d'amplificateurs opérationnels.

L'amplificateur 18 émet en sortie un signal S18 tel que :

$$S18 = (I_{Nmax} - I_1) . F(E15) \qquad (3)$$

où $I_{Nmax}$ est le courant neutre $I_N$ maximal autorisé par le chargeur 4 et F est une fonction polynomiale du troisième degré :

$$F(X) = a_0 + a_1 X + a_2 X^2 + a_3 X^3 \qquad (3)$$

les coefficients $a_0$, $a_1$, $a_2$ et $a_3$ étant des paramètres de réglage dont leur détermination est exposée dans ce qui suit.

Le modèle dynamique comprend une fonction de transfert du premier ordre H du type :

$$H(s) = \frac{n_1 + n_2 s}{d_1 + d_2 s} \qquad (4)$$

où s est l'opérateur de Laplace, et les coefficients n1, n2, d1 et d2 sont des paramètres de réglage dont leur détermination est exposée dans ce qui suit.

Le modèle dynamique génère en sortie un signal S19.

L'additionneur 20 délivre la consigne de charge comprenant le courant de consigne de charge $I_C$ de sorte que :

$$I_C = I_1 + S19 \qquad (5)$$

La figure 3 illustre un exemple de mise en oeuvre du dispositif 11 d'estimation et de compensation des courants de fuite.

Avant d'utiliser le dispositif 11, il est nécessaire de déterminer la valeur des coefficients n1, n2, d1 et d2 de la fonction de transfert du premier ordre H, le coefficient $\beta$ de sensibilité et les coefficients $a_0$, $a_1$, $a_2$ et $a_3$ de la fonction polynomiale P.

Dans une étape 30 de calibrage, les coefficients n1, n2, d1 et d2 de la fonction de transfert du premier ordre H sont déterminés à partir de valeurs figurant par exemple dans l'état de la technique et dépendent notamment des caractéristiques du chargeur 4 assimilable à un circuit RLC, le réseau R et une estimation des capacités parasites.

Bien entendu, le dispositif 11 peut être utilisé pour estimer et compenser les courants de fuite pour tout type de chargeur, le modèle dynamique et la valeur admissible des courants de fuite $I_{diffmax}$ étant adaptés au type de chargeur et au système piloté. Le modèle dynamique peut notamment comprendre une fonction d'ordre supérieur à un.

La fonction d'amplification peut également être adaptée au type de chargeur, notamment la consigne de courant neutre maximale est remplacée par la consigne de courant maximal à réguler selon le type de circuit dans d'autres topologies de chargeur. Une autre fonction d'amplification que la fonction F peut également être utilisée.

Une autre méthode de détermination des coefficients n1, n2, d1 et d2 peut reposer par exemple sur une identification fréquentielle du chargeur 4.

Durant cette étape, la valeur du coefficient $\beta$ de sensibilité est déterminée.

Puis, lorsque les coefficients n1, n2, d1, d2 et $\beta$ ont été déterminés, les coefficients $a_0$, $a_1$, $a_2$ et $a_3$ de la fonction polynomiale F sont déterminés de manière empirique de sorte que la différence E15 pondérée soit nulle en statique.

Les coefficients n1, n2, d1, d2 et $\beta$ fixent une valeur d'amplification de la différence E15 en régime transitoire.

La valeur d'amplification est déterminée en testant la réponse du chargeur pour chaque point de fonctionnement.

Chaque point de fonctionnement est pris en compte.

Bien entendu, la fonction F peut être d'un ordre inférieur ou supérieur au troisième ordre.

Puis, dans une étape 31, lorsque le chargeur 4 est relié à l'infrastructure de charge 2, les moyens d'identification 17 déterminent le type du réseau R, la valeur du courant $I_{diffmax}$ et le seuil Se1 de déclenchement.

Dans une étape 32, les moyens de mesure 13 mesurent le courant résiduel différentiel $I_{diff}$.

Si le courant $I_{diff}$ est supérieur au seuil Se1 (étape 33), la consigne de charge comprend une consigne de charge sécuritaire comprenant le courant de charge sécuritaire Ics configuré pour limiter la valeur des courants de fuite au courant $I_{diffmax}$ de manière à ne pas interrompre la charge, le courant de charge sécuritaire Ics étant égal à :

$$I_{CS} = I_1 + S19 \quad (6)$$

Si le courant $I_{diff}$ est inférieur au seuil Se1 (étape 34), la consigne de charge comprenant la consigne de courant de charge Ic est égal à :

$$I_C = I_1 \quad (7)$$

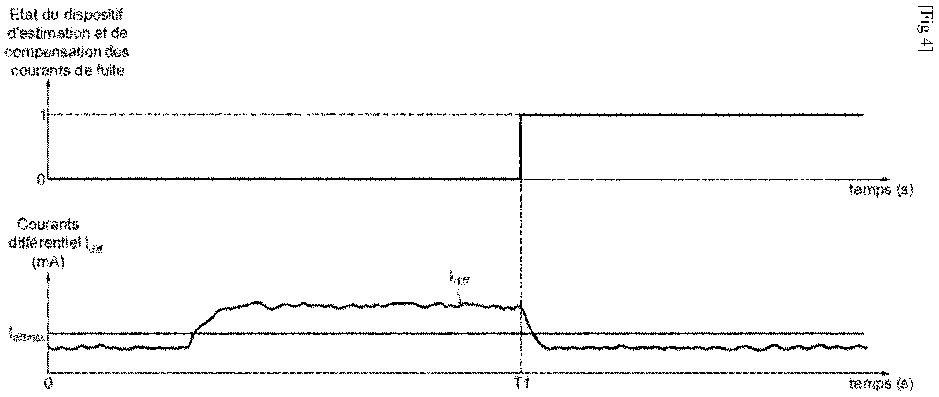

La figure 4 représente un exemple d'évolution temporelle du courant différentiel $I_{diff}$ selon l'état d'activation du dispositif 11.

Entre 0 et l'instant T1, le dispositif 11 est à l'état « 0 » c'est-à-dire désactivé. Le courant $I_{diff}$ est supérieur au courant $I_{diffmax}$ entraînant une coupure de la charge de la batterie 5 pour préserver le chargeur 4 et l'utilisateur.

A partir de l'instant T1, le dispositif 11 est activé (« 1 »). Le courant de fuite $I_{diff}$ est inférieur ou égal au courant $I_{diffmax}$ de sorte que la charge n'est pas interrompue.

Comme généralement les véhicules électriques et hybrides existant comprennent des moyens de mesure 13, le dispositif 11 nécessite uniquement l'ajout du module 14 comprenant des algorithmes de calcul.

Comme le dispositif 11 ne nécessite pas de modification matérielle (« hardware »), l'implémentation du dispositif 11 n'entraîne pas d'interférence électromagnétique avec des éléments du chargeur 4.

En outre, comme le dispositif 11 se déclenche lorsque le courant $I_{diff}$ est supérieur au seuil Se1, la performance de la charge de la batterie 4 est diminuée de manière temporaire, la charge n'étant pas interrompue avant que la batterie 4 soit complètement chargée.

## Revendications

**1.** Procédé d'estimation et de compensation des courants de fuite d'un chargeur (4) de batterie pour véhicule (1) automobile électrique ou hybride, comportant, lors d'une charge, la mesure d'un courant résiduel différentiel ($I_{diff}$) entre le chargeur et un réseau (R) d'alimentation du chargeur, la comparaison du courant résiduel à un seuil de déclenchement (Sel), et la détermination d'une consigne de charge (Ic) à partir d'un profil de charge ($P_R$) prédéterminé selon le résultat de la comparaison, **caractérisé en ce que** lorsque le courant résiduel est supérieur au seuil de déclenchement, la consigne de charge comprend une consigne de charge sécuritaire (Ics) configurée pour limiter la valeur des courants de fuite à une valeur admissible des courants de fuite ($I_{diffmax}$) de manière à ne pas interrompre la charge, la consigne de charge sécuritaire ($I_{CS}$) étant déterminée à partir de la différence entre le courant résiduel différentiel ($I_{diff}$) mesuré et le seuil de déclenchement (Se1), ladite différence étant amplifiée par un amplificateur à gain variable dépendant d'un courant ($I_1$) déterminé à partir du profil de charge puis injectée en entrée d'un filtre (19) implémentant un modèle dynamique, la sortie dudit modèle dynamique étant ajoutée au courant déterminé à partir du profil de charge pour fournir ladite consigne de charge sécuritaire.

2. Procédé selon la revendication 1, comprenant l'identification du type du réseau (R) d'alimentation du chargeur et la détermination du seuil de déclenchement (Se1) et de la valeur maximale admissible des courants de fuite ($I_{diffmax}$) en fonction du type du réseau d'alimentation identifié.

3. Procédé selon l'une des revendications 1 et 2, dans lequel le modèle dynamique comprend une fonction de transfert du premier ordre (H), la détermination des paramètres de la fonction de transfert comprenant une identification fréquentielle de l'infrastructure de charge.

4. Procédé selon l'une des revendications 1 à 3, dans lequel le gain variable dépend d'une fonction polynomiale (F).

5. Procédé selon la revendication 4, dans lequel les coefficients de la fonction polynomiale (F) sont déterminés de manière empirique.

6. Dispositif (11) d'estimation et de compensation des courants de fuite d'un chargeur (4) de batterie pour véhicule automobile (1) électrique ou hybride, comportant des moyens de mesure (13) d'un courant configurés pour mesurer, lors d'une charge, un courant résiduel différentiel ($I_{diff}$) entre le chargeur et un réseau d'alimentation (R) du chargeur, des premiers moyens de comparaison (15) configurés pour comparer le courant résiduel mesuré à un seuil de déclenchement (Sel), et des moyens de traitement (16) configurés pour déterminer une consigne de charge à partir d'un profil de charge ($P_R$) prédéterminé, **caractérisé en ce que** les moyens de traitement sont configurés pour déterminer, lorsque le courant résiduel est supérieur au seuil de déclenchement, une consigne de charge comprenant une consigne de charge sécuritaire ($I_{CS}$) configurée pour limiter la valeur des courants de fuite à une valeur admissible des courants ($I_{diffmax}$) de fuite de manière à ne pas interrompre la charge, lesdits moyens de traitement comportant un amplificateur à gain variable de la différence entre le courant résiduel différentiel ($I_{diff}$) mesuré et le seuil de déclenchement (Sel), ledit amplificateur à gain variable dépendant d'un courant ($I_1$) déterminé à partir du profil de charge et étant connecté en entrée d'un filtre (19) implémentant un modèle dynamique, la sortie dudit filtre étant connectée à un additionneur (20) additionnant ladite sortie dudit filtre et le courant déterminé à partir du profil de charge pour fournir ladite consigne de charge sécuritaire.

7. Dispositif selon la revendication 6, comportant des moyens d'identification (17) configurés pour identifier le type de réseau d'alimentation (R) du chargeur, les moyens d'identification étant en outre configurés pour déterminer le seuil de déclenchement (Se1) et la valeur admissible des courants de fuite ($I_{diffmax}$) en fonction du type du réseau d'alimentation identifié.

8. Dispositif selon l'une des revendications 6 et 7, dans lequel le modèle dynamique est configuré pour approximer le comportement dynamique de l'infrastructure de charge comprenant le réseau d'alimentation relié au chargeur et les courants de fuite.

9. Dispositif selon la revendication 8, dans lequel le modèle dynamique comprend une fonction de transfert du premier ordre (H).

10. Véhicule (1) automobile électrique ou hybride comprenant un chargeur de batterie (4) comportant un régulateur de charge (10) et un dispositif (11) d'estimation et de compensation des courants de fuite d'un chargeur selon l'une des revendications 6 à 9, ledit dispositif pilotant le régulateur de charge.

**Patentansprüche**

1. Verfahren zur Schätzung und Kompensation der Leckströme eines Batterieladegeräts (4) für ein Elektro- oder Hybridkraftfahrzeug (1), beinhaltend, bei einem Laden, das Messen eines differenziellen Reststroms ($I_{diff}$) zwischen dem Ladegerät und einem Versorgungsnetz (R) des Ladegeräts, das Vergleichen des Reststroms mit einem Auslöseschwellenwert (Se1) und das Bestimmen eines Ladesollwerts (Ic) anhand eines vorbestimmten Ladeprofils ($P_R$) gemäß dem Ergebnis des Vergleichs, **dadurch gekennzeichnet, dass**, wenn der Reststrom größer als der Auslöseschwellenwert ist, der Ladesollwert einen Sicherheitsladesollwert ($I_{CS}$) umfasst, der dazu ausgestaltet ist, den Wert der Leckströme auf einen zulässigen Wert der Leckströme ($I_{diffmax}$) zu begrenzen, so dass das Laden nicht unterbrochen wird, wobei der Sicherheitsladesollwert ($I_{CS}$) anhand der Differenz zwischen dem gemessenen differenziellen Reststrom ($I_{diff}$) und dem Auslöseschwellenwert (Se1) bestimmt wird, wobei die Differenz durch einen Verstärker mit variabler Verstärkung verstärkt wird, der von einem Strom ($I_1$) abhängig ist, der anhand eines Ladeprofils bestimmt wird, dann im Eingang eines Filters (19) eingespeist wird, der ein dynamisches Modell implementiert, wobei der Ausgang des dynamischen Modells zu dem Strom addiert wird, der anhand des Ladeprofils bestimmt wird, um den Sicherheitsladesollwert auszugeben.

2. Verfahren nach Anspruch 1, umfassend die Identifizierung des Typs des Versorgungsnetzes (R) des Ladegeräts und die Bestimmung des Auslöseschwellenwerts (Se1) und des höchstzulässigen Werts der Leckströme ($I_{diffmax}$) in Abhängigkeit von dem identifizierten Typ des Versorgungsnetzes.

3. Verfahren nach einem der Ansprüche 1 und 2, bei dem das dynamische Modelle eine Übertragungsfunktion erster Ordnung (H) umfasst, wobei die Bestimmung der Parameter der Übertragungsfunktion eine Frequenzidentifizierung der Ladeinfrastruktur umfasst.

4. Verfahren nach einem der Ansprüche 1 bis 3, bei dem die variable Verstärkung von einer Polynomfunktion (F) abhängig ist.

5. Verfahren nach Anspruch 4, bei dem die Koeffizienten der Polynomfunktion (F) empirisch bestimmt werden.

6. Vorrichtung (11) zur Schätzung und Kompensation der Leckströme eines Batterieladegeräts (4) für ein Elektro- oder Hybridkraftfahrzeug (1), beinhaltend Mittel zum Messen (13) eines Stroms, die dazu ausgestaltet sind, bei einem Laden einen differenziellen Reststrom ($I_{diff}$) zwischen dem Ladegerät und einem Versorgungsnetz (R) des Ladegeräts zu messen, erste Vergleichsmittel (15), die dazu ausgestaltet sind, den gemessenen Reststroms mit einem Auslöseschwellenwert (Se1) zu vergleichen, und Verarbeitungsmittel (16), die dazu ausgestaltet sind, einen Ladesollwert anhand eines vorbestimmten Ladeprofils ($P_R$) zu bestimmen, **dadurch gekennzeichnet, dass** die Verarbeitungsmittel dazu ausgestaltet sind, wenn der Reststrom größer als der Auslöseschwellenwert ist, einen Ladesollwert zu bestimmen, der einen Sicherheitsladesollwert ($I_{CS}$) umfasst, der dazu ausgestaltet ist, den Wert der Leckströme auf einen zulässigen Wert der Leckströme ($I_{diffmax}$) zu begrenzen, so dass das Laden nicht unterbrochen wird, wobei die Verarbeitungsmittel einen Verstärker mit variabler Verstärkung der Differenz zwischen dem gemessenen differenziellen Reststrom ($I_{diff}$) und dem Auslöseschwellenwert (Se1) umfassen, wobei der Verstärker mit variabler Verstärkung von einem Strom ($I_1$) abhängig ist, der anhand eines Ladeprofils bestimmt wird, und im Eingang eines Filters (19) angeschlossen ist, der ein dynamisches Modell implementiert, wobei der Ausgang des Filters an einen Addierer (20) angeschlossen ist, der den Ausgang des Filters und den anhand des Ladeprofils bestimmten Strom addiert, um den Sicherheitsladesollwert auszugeben.

7. Vorrichtung nach Anspruch 6, beinhaltend Identifizierungsmittel (17), die dazu ausgestaltet sind, den Typ des Versorgungsnetzes (R) des Ladegeräts zu identifizieren, wobei die Identifizierungsmittel ferner dazu ausgestaltet sind, den Auslöseschwellenwert (Se1) und den zulässigen Wert der Leckströme ($I_{diffmax}$) in Abhängigkeit von dem identifizierten Typ des Versorgungsnetzes zu bestimmen.

8. Vorrichtung nach einem der Ansprüche 6 und 7, bei der das dynamische Modell dazu ausgestaltet ist, das dynamische Verhalten der Ladeinfrastruktur, die das mit dem Ladegerät verbundene Versorgungsnetz umfasst, und die Leckströme zu approximieren.

9. Vorrichtung nach Anspruch 8, bei der das dynamische Modell eine Übertragungsfunktion erster Ordnung (H) umfasst.

10. Elektro- oder Hybridkraftfahrzeug (1), das ein Batterieladegerät (4) umfasst, das einen Laderegler (10) und eine Vorrichtung (11) zur Schätzung und Kompensation der Leckströme eines Ladegeräts nach einem der Ansprüche 6 bis 9 beinhaltet, wobei die Vorrichtung den Laderegler steuert.

**Claims**

1. Method for estimating and compensating for leakage currents of a battery charger (4) for an electric or hybrid motor vehicle (1), including, during charging, measuring a differential residual current ($I_{diff}$) between the charger and a supply network (R) for the charger, comparing the residual current with a tripping threshold (Sel), and determining a charging setpoint ($I_C$) from a predetermined charging profile ($P_R$) according to the result of the comparison, **characterized in that** when the residual current is higher than the tripping threshold, the charging setpoint comprises a safe charging setpoint ($I_{CS}$) configured to limit the value of leakage currents to an allowable value of leakage currents ($I_{diffmax}$) so as not to interrupt the charging, the safe charging setpoint ($I_{CS}$) being determined from the difference between the measured differential residual current ($I_{diff}$) and the tripping threshold (Sel), said difference being amplified by an amplifier with a variable gain that depends on a current ($I_1$) determined from the charging profile, and then injected into an input of a filter (19) implementing a dynamic model, the output of said dynamic model being added to the current determined from the charging profile in order to provide said safe charging setpoint.

2. Method according to Claim 1, comprising the identification of the type of network (R) supplying the charger and the determination of the tripping threshold (Se1) and of the allowable maximum value of leakage currents ($I_{diffmax}$) as a function of the identified supply network type.

3. Method according to either Claim 1 or Claim 2, in which the dynamic model comprises a first-order transfer function (H), the determination of the parameters of the transfer function comprising a frequency-domain identification of the charging infrastructure.

4. Method according to one of Claims 1 to 3, in which the variable gain is dependent on a polynomial function (F).

5. Method according to Claim 4, in which the coefficients of the polynomial function (F) are determined empirically.

6. Device (11) for estimating and compensating for leakage currents of a battery charger (4) for an electric or hybrid motor vehicle (1), including current measurement means (13) configured to measure, during charging, a differential residual current ($I_{diff}$) between the charger and a supply network (R) for the charger, first comparison means (15) configured to compare the measured residual current with a tripping threshold (Sel), and processing means (16) configured to determine a charging setpoint from a predetermined charging profile ($P_R$), **characterized in that** the processing means are configured to determine, when the residual current is higher than the tripping threshold, a charging setpoint comprising a safe charging setpoint ($I_{CS}$) configured to limit the value of leakage currents to an allowable value of leakage currents ($I_{diffmax}$) so as not to interrupt the charging, said processing means including a variable gain amplifier for the difference between the measured differential residual current ($I_{diff}$) and the tripping threshold (Sel), said variable gain amplifier being dependent on a current ($I_1$) determined from the charging profile and being connected at an input of a filter (19) implementing a dynamic model, the output of said filter being connected to an adder (20) adding said output of said filter and the current determined from the charging profile in order to provide said safe charging setpoint.

7. Device according to claim 6, including identification means (17) configured to identify the type of supply network (R) for the charger, the identification means additionally being configured to determine the tripping threshold (Se1) and the allowable value of leakage currents ($I_{diffmax}$) as a function of the identified supply network type.

8. Device according to either Claim 6 or Claim 7, in which the dynamic model is configured to approximate the dynamic behaviour of the charging infrastructure comprising the supply network connected to the charger and the leakage currents.

9. Device according to Claim 8, in which the dynamic model comprises a first-order transfer function (H).

10. Electric or hybrid motor vehicle (1) comprising a battery charger (4) including a charging controller (10) and a device (11) for estimating and compensating for leakage currents of a charger according to one of Claims 6 to 9, said device driving the charging controller.

[Fig 1]

[Fig 2]

[Fig 3]

[Fig 4]

EP 4 029 107 B1

Etat du dispositif
d'estimation et de
compensation des
courants de fuite

1

0

temps (s)

Courants
différentiel $I_{diff}$
(mA)

$I_{diff}$

$I_{diffmax}$

0

T1

temps (s)

**RÉFÉRENCES CITÉES DANS LA DESCRIPTION**

**Documents brevets cités dans la description**

- US 2012019194 A1
- CN 204967321 U
- US 2011273139 A1
- US 9696743 B

**Littérature non-brevet citée dans la description**

- **S. HAGHBIN ; S. LUNDMARK ; M. ALAKÜLA ; O. CARLSON.** Grid-Connected Integrated Battery Chargers in Vehicle Applications: Review and New Solution. *IEEE TRANSACTIONS ON INDUSTRIAL ELECTRONICS,* Février 2013, vol. 60 (2
- **I. SUBOTIC ; N. BODO ; E. LEVI ; B. DUMNIC ; D. MILICEVIC ; V. KATIC.** Overview of fast on-board integrated battery chargers for electric vehicles based on multiphase machines and power electronics. *IET Electric Power Applications,* ISSN 1751-8660
- **YILMAZ ; P. T. KREIN.** Review of Battery Charger Topologies, Charging Power Levels, and Infrastructure for Plug-In Electric and Hybrid Vehicles. *IEEE TRANSACTIONS ON POWER ELECTRONICS,* Mai 2013, vol. 28 (5
- **Y. ZHANG et al.** Leakage Current Issue of Non-Isolated Integrated Chargers for Electric Vehicles. *Proceedings of the 2018 IEEE Energy Conversion Congress and Exposition (ECCE)*